# EUROPEAN PATENT APPLICATION

(11) **EP 2 826 674 A2**
(43) Date of publication of application: **21.01.2015**
(21) Application number: 14173834.4
(22) Date of filing: 25.06.2014
(51) Int. Cl.: B60R 16/023

(54) **Electrical center for a vehicle**

(30) Priority: 15.07.2013 US 201313942058
(71) Applicant: Delphi Technologies, Inc., Troy MI 48007 (US)
(72) Inventor: Borowicz, Theodore J., Flat Rock, MI 48134 (US); Stern, Eric J., Farmington Hills, MI 48334 (US); Mosby, William J., Redford, MI 48240 (US)
(74) Representative: Allart, René Paul Pruli Slamet

(57) **Abstract**

An electrical center (12) for distributing electrical power to an electrical system (14) of a vehicle (10) is provided. The electrical center (12) includes a printed circuit board (PCB) (28) that is configured to fit inside of a cover (32). The PCB (28) includes a first electrical component (30) that is electrically connected to the electrical system (14). A first retainer (36) is configured to secure the PCB (28) to the cover (32) and to protect an exposed side of the PCB (28). The cover (32), the PCB (28), and the first retainer (36) cooperate to form an assembly (24) that protects the PCB (28) when shipped. A base (26) is configured to mechanically and electrically couple with the assembly (24). The base (26) includes a second electrical component (46) that is electrically connected to the electrical system (14).

## Description

### TECHNICAL FIELD OF INVENTION

This disclosure generally relates to an electrical center for distributing electrical power, and more particularly to an electrical center for distributing electrical power to an electrical system of a vehicle.

### BACKGROUND OF INVENTION

Motor vehicles typically are equipped with an electrical center (EC) that distributes electrical power to an electrical system of the vehicle. The EC typically includes fuses to protect electrical components of the electrical system from damage caused by short circuits. ECs are sometimes referred to as fuse blocks or fuse boxes.

One type of EC design is known as a hybrid design. The hybrid design utilizes a hardwired portion and a printed circuit board (PCB) portion to mount and electrically connect electrical components of the EC, such as fuses and relays, to the electrical system. The hardwired portion includes a plastic housing that holds terminals of the electrical system in place such that certain electrical components of the EC can be directly mounted and electrically connected to the terminals. The PCB portion includes a PCB that is populated with additional electrical components of the EC. The electrical components of the PCB are electrically connected to the electrical system via connector terminals that extend from the PCB. Typically, the hardwired portion and the PCB portion are strategically designed to optimize the overall cost and performance of the EC. The hardwired portion is typically lower in cost, whereas the PCB portion typically provides improved performance.

One drawback of the known hybrid design is that the PCB portion can sustain damage as a result of the multiple times the PCB portion is handled and/or shipped prior to the EC being assembled to the vehicle. For example, the PCB portion may be handled and /or shipped by the PCB manufacturer, EC manufacturer, vehicle sequencer, and the vehicle assembly plant.

### SUMMARY OF THE INVENTION

In accordance with one embodiment an electrical center for distributing electrical power to an electrical system of a vehicle is provided. The electrical center comprises a cover. The electrical center further comprises a printed circuit board (PCB) that is configured to fit inside of the cover. The PCB includes a first electrical component that is electrically connected to the electrical system. The electrical center further comprises a first retainer that is configured to secure the PCB to the cover and protect an exposed side of the PCB. The cover, the PCB, and the first retainer cooperate to form an assembly that protects the PCB when shipped. The electrical center further comprises a base that is configured to mechanically and electrically couple with the assembly. The base includes a second electrical component that is electrically connected to the electrical system.

### BRIEF DESCRIPTION OF DRAWINGS

The present invention will now be described, by way of example with reference to the accompanying drawings, in which:
Fig. 1 is an illustration of a vehicle equipped with an electrical center;
Fig. 2 is an illustration of the electrical center;
Fig. 3 is a first illustration of the electrical center with an assembly of the electrical center swung open;
Fig 4 is a second illustration of the electrical center with the assembly swung open; and
Fig 5 is an exploded illustration of the electrical center.

### DETAILED DESCRIPTION

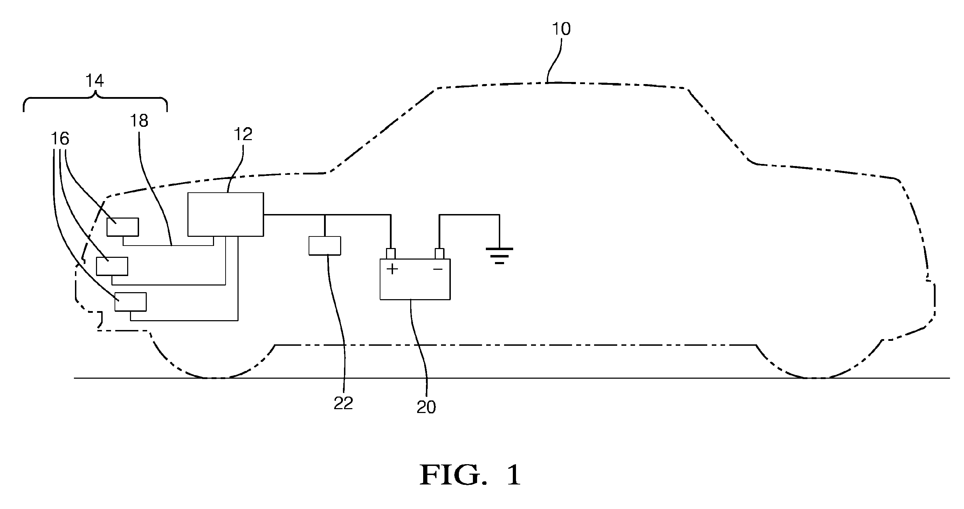

Fig. 1 illustrates a non-limiting example of a vehicle 10 equipped with an electrical center 12. The electrical center 12 distributes electrical power to an electrical system 14 of the vehicle 10. The electrical system 14 typically includes various devices 16 of the vehicle 10, such as a horn, headlamps, power steering motor, etc., and the associated wiring harness 18 that is required to carry electrical power from the electrical center 12 to each of the devices 16. In general, the electrical center 12 receives electrical power from a battery 20 and an alternator 22 of the vehicle 10. The electrical center 12 limits the flow of electrical power (i.e. current) being distributed to the electrical system 14 such that damage does not occur to the electrical system 14 as a result of a short circuit within the electrical system 14.

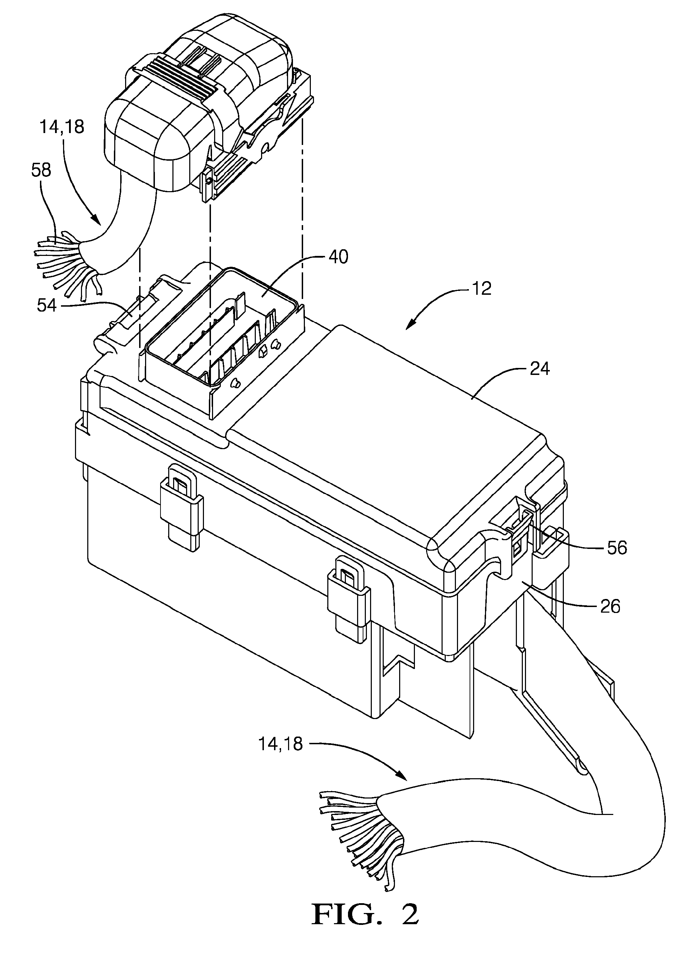

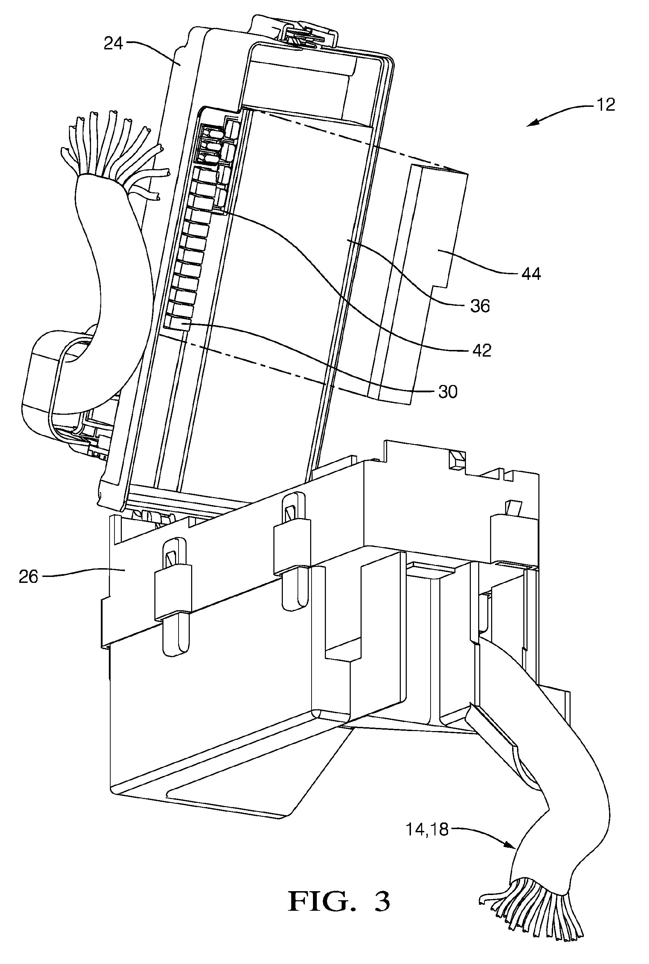

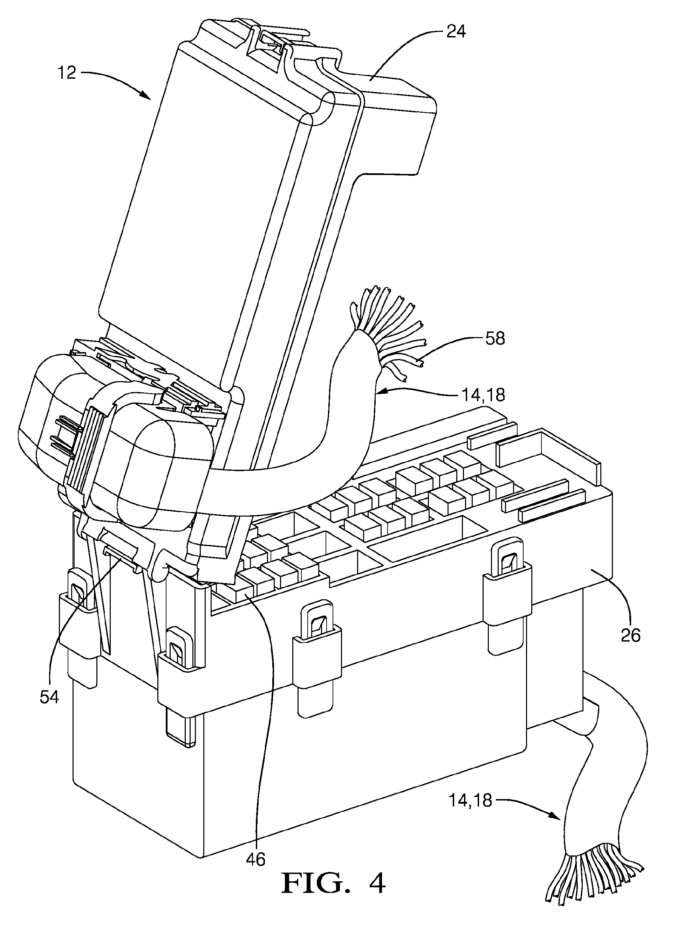

Figs. 2 - 5 illustrate a non-limiting example of the electrical center 12. The electrical center 12 includes an assembly 24 and a base 26 that are configured to mechanically and electrically coupled together to form the electrical center 12.

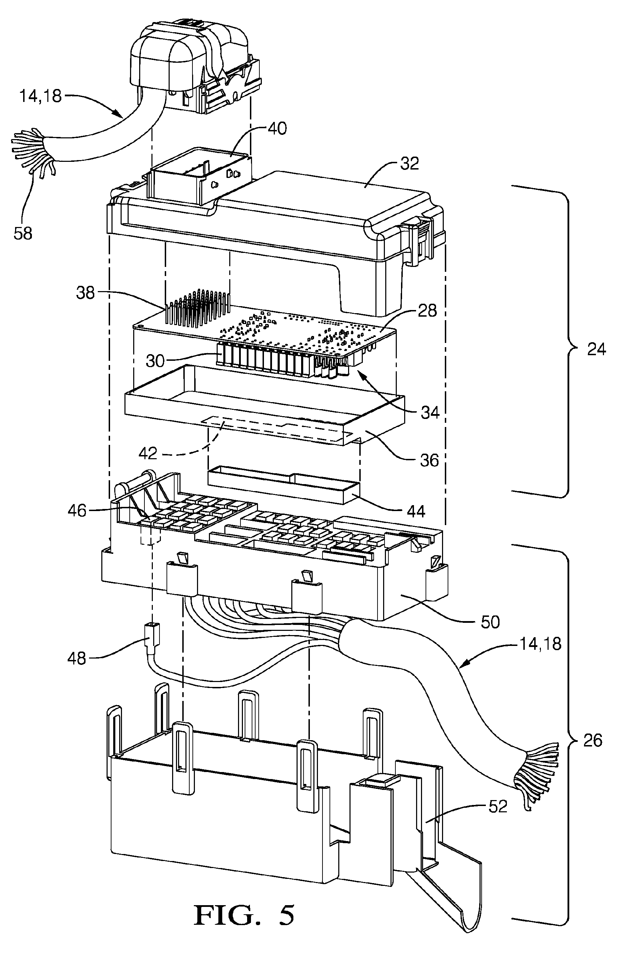

The assembly 24 of the electrical center 12 includes a printed circuit board (PCB) 28 as shown in Fig. 5. The PCB 28 generally includes at least a first electrical component 30 that is electrically connected to the electrical system 14. The first electrical component 30 may be, but is not limited to, a fuse, a relay, a transistor, or any other electrical component suitable to mount on the PCB 28, as will be recognized by those in the art. The PCB 28 is configured to fit inside of a cover 32. The first electrical component 30 may be electrically connected to the electrical system 14 via a first terminal 38 on the PCB 28 that extends through an access opening 40 in the cover 32. A first retainer 36 is configured to secure the PCB 28 to the cover 32 and to protect an exposed side 34 of the PCB 28. The cover 32, the PCB 28, and the first retainer 36 cooperate to form the assembly 24 that protects the PCB 28 when shipped. For example, when the assembly 24 is shipped to an assembly plant for the vehicle 10. The cover 32 and the first retainer 36 are preferably made of plastic.

The first retainer 36 of the assembly 24 may be further configured to include a service opening 42. The service opening 42 is configured to allow the first electrical component 30 to be serviced without the removal of the first retainer 36. For example, to replace a blown fuse. A second retainer 44 may be added to the assembly 24 to retain the first electrical component 30 to the PCB 28 and to protect the first electrical component 30 when the assembly 24 is shipped. For example, to retain and protect a serviceable fuse that may protrude outwards of the first retainer 36.

The base 26 of the electrical center 12 generally includes at least a second electrical component 46 that is electrically connected to the electrical system 14. The second electrical component 46 may be, but is not limited to, a fuse, a relay, or any other electrical component suitable for distributing electrical power to the electrical system 14, as will be recognized by those in the art. The second electrical component 46 may be mounted (i.e. hardwired) on a wire terminal 48 of the electrical system 14 that is retained within the base 26 by a housing 50. The base 26 may further include a harness cover 52 that is configured to route and protect portions of the wiring harness 18 that are electrically connected to the electrical center 12 at the base 26. Both the housing 50 and the harness cover 52 are preferably made of plastic.

The assembly 24 and base 26 are configured such that the assembly 24 and base 26 may be manufactured and shipped separately for assembly to the vehicle 10. For example, the base 26 may be assembled to the vehicle 10 first, followed by the assembly 24 which is then coupled to the base 26. Since the assembly 24 may be manufactured, shipped, and installed separately from the base 26, the PCB 28 will not be exposed to potentially damaging loads that may be generated during the manufacturing, shipping, sequencing, handling, and/or installation of the base 26. Additionally, this allows for the utilization of unique packaging and/or shipping for the assembly 24 separate from the base 26 to further protect the PCB 28 from shipping damage.

The assembly 24 and the base 26 of the electrical center 12 may be mechanically coupled via a hinge 54 and a locking feature 56 as shown in Fig. 2. The assembly 24 and the base 26 may be electrically coupled via a wire 58 of the wiring harness 18 that carries electrical power from the base 26 to the assembly 24. Alternatively, the assembly 24 and base 26 may be electrically coupled via electrical contacts (not shown) that are opposite the hinge 54 and exposed such that an electrical connection is made when the assembly 24 and base 26 are mechanically coupled.

Accordingly, an electrical center 12 for a vehicle 10 is provided. The electrical center 12 provides improved quality and reliability over known hybrid electrical center designs that may incur PCB damage as a result of manufacturing, shipping, handling and/or installation.

## Claims

1. Electrical center (12) for distributing electrical power to an electrical system (14) of a vehicle (10), said electrical center (12) comprising:
a cover (32);
a printed circuit board (PCB) (28) configured to fit inside of the cover (32), wherein the PCB (28) includes a first electrical component (30) that is electrically connected to the electrical system (14);
a first retainer (36) configured to secure the PCB (28) to the cover (32) and to protect an exposed side of the PCB (28), wherein the cover (32), the PCB (28), and the first retainer (36) cooperate to form an assembly (24) that protects the PCB (28) when shipped; and
a base (26) configured to mechanically and electrically couple with the assembly (24), wherein the base (26) includes a second electrical component (46) that is electrically connected to the electrical system (14).

2. Electrical center (12) of claim 1, wherein the second electrical component (46) is mounted on a wire terminal (48) of the electrical system (14) that is retained within the base (26).

3. Electrical center (12) according to one of the claims 1-2, wherein the first electrical component (30) is electrically connected to the electrical system (14) via a first terminal (38) on the PCB (28) that extends through an access opening (40) in the cover (32).

4. Electrical center (12) according to one of the claims 1-3, wherein the first retainer (36) is further configured to include a service opening (42) configured to allow the first electrical component (30) to be serviced without removal of the first retainer (36).

5. Electrical center (12) according to one of the claims 1-4, wherein the assembly (24) further includes a second retainer (44) configured to retain the first electrical component (30) to the PCB (28) and to protect the first electrical component (30) when the assembly (24) is shipped.
